# EUROPÄISCHE PATENTSCHRIFT

(11) **EP 1 763 896 B1**
(45) Veröffentlichungstag und Bekanntmachung des Hinweises auf die Patenterteilung: **03.10.2018**
(21) Anmeldenummer: 05766697.6
(22) Anmeldetag: 13.06.2005
(51) Int. Cl.: H01L 25/075

(54) **LEUCHTDIODENANORDNUNG UND OPTISCHES AUFZEICHNUNGSGERÄT**
LIGHT-EMITTING DIODE ARRANGEMENT AND OPTICAL RECORDING DEVICE
ENSEMBLE DIODE ELECTROLUMINESCENTE ET APPAREIL D'ENREGISTREMENT OPTIQUE

(30) Priorität: 30.06.2004 DE 102004031689; 31.08.2004 DE 102004042185
(43) Veröffentlichungstag der Anmeldung: 21.03.2007
(73) Patentinhaber: OSRAM Opto Semiconductors GmbH, 93055 Regensburg (DE)
(72) Erfinder: FARCHTCHIAN, Nadir, Santa Clara, CA 95054 (DE); KIRCHBERGER, Günter, 93161 Sinzing (DE); KUHN, Gerhard, 93096 Köfering (DE); ROSE, Monika, 81825 München (DE); SAILER, Michael, 93098 Wolfskofen (DE); STICH, Andreas, 93049 Regensburg (DE)
(74) Vertreter: Epping - Hermann - Fischer
(86) Internationale Anmeldenummer: PCT/DE2005/001053
(87) Internationale Veröffentlichungsnummer: WO 2006/002607

(56) Entgegenhaltungen:
- DE-A1- 4 107 526
- DE-U1- 20 220 900
- JP-U- H0 684 491
- US-A1- 2004 075 399
- US-B1- 6 525 386

## Beschreibung

Die Erfindung betrifft eine Leuchtdiodenanordnung und ein optisches Aufzeichnungsgerät.

Die Druckschrift US 4,843,416 A beschreibt eine Autofokuskamera mit einer Licht emittierenden Diode und einem Puls erzeugenden Stromkreis. Mit Hilfe des Puls erzeugenden Stromkreises wird durch die Diode ein einzelner Lichtblitz erzeugt. Eine Fotodiode empfängt den durch ein Objekt reflektierten Lichtpuls. Mit Hilfe der Amplitude des empfangenen Lichtpulses wird die Entfernung zum Objekt bestimmt.

Die Druckschrift US 6,185,240 B1 beschreibt eine Laserdiode, zu der eine zweite Diode antiparallel geschaltet ist. Die zweite Diode stellt dabei einen Schutz gegen elektrostatische Entladung (ESD - electro static discharge) für die Laserdiode dar. Sie schützt die Laserdiode vor ESD-Spannungspulsen, die in Sperrrichtung der Laserdiode auftreten können.

Die Druckschrift WO 98/12757 A1 beschreibt ein Halbleiterbauteil mit einem strahlungsemittierenden Halbleiterchip, der elektromagnetische Strahlung im blauen Spektralbereich zwischen 420 nm und 460 nm abstrahlt. Der Halbleiterchip ist zumindest teilweise von einer Vergussmasse umschlossen, die ein Lumineszenz-Konversionsmaterial enthält, das geeignet ist, einen Teil der vom Halbleiterchip abgegebenen Strahlung in eine Strahlung längerer Wellenlänge, bevorzugt im gelben Spektralbereich, zu konvertieren. Das Halbleiterbauteil strahlt daher Mischstrahlung ab, die sich aus dem wellenlängenkonvertierten Anteil der Strahlung und der ursprünglichen Strahlung des Halbleiterchips zusammensetzt. Vorzugsweise strahlt das Halbleiterbauteil weißes Licht ab.

Die Druckschrift US 2004/0075399 A1 beschreibt eine Leuchtdiodenanordnung, bei der LEDs in zwei Strängen antiparallel verschaltet sind.

Aus der Druckschrift US 6,525,386 B1 ist ein LED-Bauteil zur Pulsoxymetrie mit einem rot und einem nahinfrarot emittierenden LED-Chip bekannt.

In der Druckschrift DE 41 07 526 A1 findet sich eine antiparallele Verschaltung von verschiedenfarbig emittierenden LEDs.

Der Druckschrift DE 202 20 900 U1 ist eine Navigationsleuchte mit verschiedenfarbig emittierenden LED-Chips zu entnehmen.

Eine LED-Anordnung mit zwei antiparallel geschaltete LEDs ist in der Druckschrift JP H06-084491 U beschrieben.

Aufgabe der vorliegenden Erfindung ist es, eine Leuchtdiodenanordnung anzugeben, die besonders vielseitig einsetzbar ist. Weiter ist es eine Aufgabe der vorliegenden Erfindung, ein möglichst kompaktes und Strom sparendes optisches Aufzeichnungsgerät mit solch einer Leuchtdiodenanordnung anzugeben.

Diese Aufgabe wird durch eine Leuchtdiodenanordnung gemäß Anspruch 1 und durch ein optisches Aufzeichnungsgerät gemäß Anspruch 9 gelöst.

Es wird eine Leuchtdiodenanordnung angegeben, die zwei Leuchtdioden aufweist, die antiparallel zueinander geschaltet sind. Das heißt, wenn an der Leuchtdiodenanordnung eine äußere Spannung anliegt, so ist eine der Leuchtdioden in Durchlassrichtung und die andere Leuchtdiode in Sperrrichtung geschaltet. Die Leuchtdioden weisen jeweils zumindest einen Leuchtdiodenchip auf. Weiter ist es möglich, dass die Leuchtdioden durch jeweils einen einzelnen Leuchtdiodenchip gebildet sind.

Weiter ist eine Vorrichtung vorgesehen, die geeignet ist, die Leuchtdioden mit Strom wechselnder Richtung zu bestromen. Das heißt beispielsweise, jede der beiden Leuchtdioden kann mittels dieser Vorrichtung abwechselnd in Durchlass- und Sperrrichtung geschaltet sein. Wenn an einer der Leuchtdioden eine Spannung in Sperrrichtung anliegt, so liegt an der anderen Leuchtdiode eine Spannung in Durchlassrichtung an. Die Leuchtdioden der Leuchtdiodenanordnung sind also geeignet abwechselnd elektromagnetische Strahlung zu emittieren. Es ist dabei darüber hinaus auch möglich, dass für eine bestimmte Zeitspanne keine Spannung an den Leuchtdioden anliegt.

Es wird also eine Leuchtdiodenanordnung angegeben, die zwei Leuchtdioden aufweist, die antiparallel zueinander geschaltet sind, und bei der eine Vorrichtung vorgesehen ist, die geeignet ist, die Leuchtdioden mit Strom wechselnder Richtung zu bestromen. Beispielsweise handelt es sich bei der Vorrichtung um eine Stromversorgung, die geeignet ist, die Leuchtdioden unabhängig voneinander in Durchlassrichtung zu bestromen.

In einer Ausführungsform der Leuchtdiodenanordnung ist die Vorrichtung geeignet die Leuchtdiodenanordnung für vorgebbare Zeitspannen mit Strom vorgebbarer Richtung und Stärke zu bestromen. Auf diese Weise können die Leuchtdioden bei Betrieb der Leuchtdiodenanordnung für vorgebbare Zeitspannen abwechselnd elektromagnetische Strahlung emittieren. Die Intensität der elektromagnetischen Strahlung kann dabei durch die vorgebbare Stärke des Stroms, mit dem die jeweilige Leuchtdiode in Durchlassrichtung betrieben wird, geregelt sein.

Bevorzugt ist die an der Leuchtdiodenanordnung anliegende Spannung dabei so klein gewählt, dass diejenige Leuchtdiode, bei der eine Spannung in Sperrrichtung anliegt, nicht beschädigt wird. Das heißt, die anliegende Spannung übersteigt die Durchbruchsspannung der Diode nicht.

Bei der durch die Vorrichtung bestromten Leuchtdiodenanordnung kann beispielsweise die Zeitspanne, für die jeweils ein Strom vorgebbarer Richtung durch die Leuchtdiodenanordnung fließen kann, so gewählt sein, dass in eine bestimmte Richtung der Strom durch die Leuchtdiodenanordnung länger fließen kann als in eine andere Richtung. Vorteilhaft wird dadurch erreicht, dass im Betrieb der Leuchtdiodenanordnung eine der Leuchtdioden für eine längere Zeitspanne elektromagnetische Strahlung emittiert, als die andere Leuchtdiode.

Bevorzugt ist die Vorrichtung zudem geeignet, dass der Strom in einer Richtung größer gewählt werden kann, als in der anderen Richtung. Beispielsweise kann so im Betrieb der Leuchtdiodenanordnung durch die Leuchtdiode, die für eine längere Zeitspanne in Durchlassrichtung bestromt wird, zusätzlich immer ein stärkerer Strom in Durchlassrichtung fließen, als durch die andere Leuchtdiode. Die andere Leuchtdiode wird dann für eine kürzere Zeitspanne mit geringerer Stromstärke in Durchlassrichtung betrieben. Darüber hinaus ist es jedoch auch möglich, die beiden Leuchtdioden für jeweils gleichlange Zeitspannen mit jeweils gleichen Stromstärken in Durchlassrichtung zu betreiben.

Besonders bevorzugt ist die Vorrichtung eine Pulsweiten-Modulationsschaltung. Bei solch einer Pulsweiten-Modulationsschaltung ist es möglich, Stromstärke, Stromrichtung und die Zeitspanne, für die ein Strom vorgebbarer Stärke und vorgebbarer Richtung fließen soll, möglichst genau und auf möglichst einfache Weise einzustellen.

In einer bevorzugten Ausführungsform der Leuchtdiodenanordnung sind die Leuchtdioden in einem gemeinsamen Gehäuse angeordnet. Die Leuchtdioden können dazu beispielsweise beide in einer Ausnehmung eines Gehäusegrundkörpers angebracht sein.

Es sind die Leuchtdioden geeignet, elektromagnetische Strahlung unterschiedlicher Wellenlänge zu emittieren. Dabei ist eine der Leuchtdioden geeignet, Licht im roten Spektralbereich zu emittieren. Die andere Leuchtdiode ist geeignet, Licht im blauen Spektralbereich zu emittieren.

Es ist ein Lumineszenz-Konversionsmaterial vorgesehen, das geeignet ist die von einer der Leuchtdioden emittierte elektromagnetische Strahlung teilweise Wellenlängen zu konvertieren. Das heißt, wenigstens einer der Leuchtdioden ist in einer Abstrahlrichtung ein Lumineszenz-Konversionsmaterial nachgeordnet, welches einen Teil der von der Leuchtdiode emittierten Strahlung absorbiert und daraufhin Strahlung einer anderen Wellenlänge emittiert. Es emittiert das Lumineszenz-Konversionsmaterial Strahlung einer größeren Wellenlänge, als die Wellenlänge der Strahlung, die ursprünglich von der Leuchtdiode emittiert wurde. Eine resultierende Strahlung ergibt sich durch Mischung des wellenlängenkonvertierten Anteils der Strahlung mit der von der Leuchtdiode ursprünglich ausgesandten Strahlung.

Bei der Verwendung von wenigstens zwei verschiedenen Leuchtstoffen, die im Lumineszenz-Konversionsmaterial enthalten sind, kann auf diese Weise Mischlicht der von den beiden Leuchtstoffen emittierten Strahlung erzeugt werden. Organische und anorganische Leuchtstoffe, die zur Wellenlängenkonvertierung elektromagnetischer Strahlung geeignet sind, sind beispielsweise in der Druckschrift WO 98/12757 A1 beschrieben.

In einer weiteren Ausführungsform der Leuchtdiodenanordnung kann das Lumineszenz-Konversionsmaterial beispielsweise in einer dünnen Schicht auf die Strahlungsauskoppelfläche wenigstens einer der Leuchtdioden aufgebracht sein. Es ist aber auch möglich, dass lediglich auf eine der Leuchtdioden ein Lumineszenz-Konversionsmaterial in einer dünnen Schicht aufgebracht ist. Weiter ist es möglich, dass auf die beiden Leuchtdioden jeweils ein Lumineszenz-Konversionsmaterial aufgebracht ist, das unterschiedliche Leuchtstoffe enthalten kann. Die Leuchtstoffe können dabei der jeweiligen elektromagnetischen Strahlung, die von der Leuchtdiode erzeugt wird, angepasst sein.

In einer weiteren Ausführungsform der Leuchtdiodenanordnung ist es möglich, dass die Leuchtdioden von einer gemeinsamen Vergussmasse umgeben sind. Bevorzugt enthält die Vergussmasse ein Lumineszenz-Konversionsmaterial. Besonders bevorzugt ist eine der Leuchtdioden geeignet, elektromagnetische Strahlung einer Wellenlänge zu emittieren, die die Vergussmasse weitgehend ungehindert durchdringen kann. Weitgehend ungehindert heißt in diesem Zusammenhang, dass die von dieser Leuchtdiode abgegebene elektromagnetische Strahlung durch das in der Vergussmasse vorhandene Lumineszenz-Konversionsmaterial nicht oder nur unwesentlich wellenlängenkonvertiert wird. Die Strahlung tritt also mit der gleichen Wellenlänge aus der Vergussmasse aus, mit der sie von der Leuchtdiode emittiert worden ist, ohne dass ein wesentlicher Anteil dieser Strahlung von Bestandteilen der Vergussmasse absorbiert wird. Zumindest ein Teil der von der anderen Leuchtdiode abgegebenen Strahlung wird bevorzugt vom Lumineszenz-Konversionsmaterial Wellenlängen konvertiert.

Der wellenlängenkonvertierte Anteil der von einer der Leuchtdioden emittierten elektromagnetischen Strahlung mischt sich mit der ursprünglich von dieser Leuchtdiode emittierten elektromagnetischen Strahlung zu Mischlicht. Das Mischlicht ist weißes Licht.

Das heißt, eine der Leuchtdioden ist geeignet, elektromagnetische Strahlung im ultraviolett-blauem Spektralbereich zu emittieren. Das Maximum der Wellenlänge der von der Leuchtdiode emittierten Strahlung liegt dabei zwischen 420 nm und 470 nm. Das Lumineszenz-Konversionsmaterial ist dann geeignet, einen Teil dieser Strahlung zu elektromagnetischer Strahlung im grün-gelben Spektralbereich zu konvertieren. Das Maximum der relativen spektralen Emission der konvertierten Strahlung liegt im Wellenlängenbereich zwischen 530 nm und 580 nm. Als Mischlicht ergibt sich weißes Licht.

In einer weiteren Ausführungsform der Leuchtdiodenanordnung ist eine der Leuchtdioden geeignet, elektromagnetische Strahlung im roten, grünen oder gelben Spektralbereich zu erzeugen.

Eine der Leuchtdioden ist geeignet, elektromagnetische Strahlung im roten Spektralbereich mit einem Maximum der Wellenlänge der emittierten Strahlung zwischen 600 nm und 750 nm zu emittieren.

Die Leuchtdiodenanordnung macht sich dabei unter Anderem die Idee zu Nutze, dass durch die Bestromung der Leuchtdiodenanordnung in wechselnder Richtung der von der Leuchtdiodenanordnung abgegebenen Strahlung ein bestimmter Anteil von rotem Licht beigemengt ist. Wird von der Leuchtdiodenanordnung weißes Licht durch teilweise Konversion von blauem Licht zu gelbem Licht abgestrahlt, so enthält das auf diese Weise erzeugte weiße Licht einen sehr geringen Rotanteil. Durch die gezielte Hinzugabe von rotem Licht mittels Bestromung der rotes Licht emittierenden Leuchtdiode für vorgebbare Zeitspannen mit einer vorgebbaren Stromstärke in Durchlassrichtung, kann dieser Mangel an rotem Licht ausgeglichen werden. Wird zusätzlich eine Leuchtdiode gewählt, die Licht beispielsweise im grünen Spektralbereich emittiert, so kann der Strahlung der Leuchtdiodenanordnung auf diese Weise ein definierter Anteil grünen Lichts beigemengt sein. Insgesamt ist der Farbwidergabeindex der Leuchtdiodenanordnung auf diese Weise erhöht.

Besonders vorteilhaft erweist sich bei der Leuchtdiodenanordnung zudem, dass die beiden antiparallel zueinander geschalteten Leuchtdioden gegenseitig ein Schutz gegen elektrostatische Entladung in Sperrrichtung sind. Derartige ESD-Spannungspulse können ein optoelektronisches Bauelement in seiner Funktion beeinträchtigen oder sogar zerstören. Fließt nun ein Strom aufgrund eines solchen ESD-Spannungspulses durch die Leuchtdiodenanordnung, so wird er durch eine der Leuchtdioden in Durchlassrichtung abgeleitet. Die Gefahr eines Durchbrechens der anderen Leuchtdiode ist damit verringert.

In einer weiteren bevorzugten Ausführungsform der Leuchtdiodenanordnung kann zu wenigstens einer der antiparallel zueinander geschalteten Leuchtdioden wenigstens eine weitere Leuchtdiode in Reihe geschaltet sein. Beispielsweise ist es möglich, dass zu einer rotes Licht emittierenden Leuchtdiode eine grünes Licht emittierende Leuchtdiode in Reihe geschaltet ist. Zu diesen beiden Leuchtdioden kann dann beispielsweise eine blaues Licht emittierende Leuchtdiode antiparallel geschaltet sein. Es ist dabei durch abwechselnde Bestromung der Leuchtdiodenanordnung möglich, beispielsweise weißes Licht mit einem erhöhten Anteil von rotem und grünem Licht zu erzeugen.

Besonders bevorzugt wird eine der eben beschriebenen Leuchtdiodenanordnungen als Beleuchtungseinrichtung in Innenbeleuchtungen von Fahrzeugen oder Flugzeugen oder in Videokameras und Photoapparaten eingesetzt. Besonders vorteilhaft erweist sich dabei eine Leuchtdiodenanordnung, die weißes Licht mit einem erhöhten Rotlichtanteil abstrahlt. So ist beispielsweise bei der Verwendung als Beleuchtungseinrichtung in der Innenbeleuchtung eines Fahrzeugs eine durch die beschriebene Leuchtdiodenanordnung ausgeleuchtete Straßenkarte besser lesbar. Auch erscheinen Personen, die mit einer solchen Leuchtdiodenanordnung ausgeleuchtet werden, weniger blass im Vergleich zu einer Ausleuchtung mit einer herkömmlichen Leuchtdiodenanordnung ohne erhöhten Rotlichtanteil. Dies erweist sich beispielsweise auch bei der Verwendung der Leuchtdiodenanordnung in Videokameras oder Photoapparaten als besonders vorteilhaft.

In einer weiteren Ausführungsform weist wenigstens eine der Leuchtdioden wenigstens einen Leuchtdiodenchip auf, bei dem ein Großteil der im Leuchtdiodenchip erzeugten elektromagnetischen Strahlung durch eine Strahlungsaustrittsfläche in Hauptabstrahlrichtung austritt oder ist durch solch einen Leuchtdiodenchip gebildet. Besonders bevorzugt tritt die elektromagnetische Strahlung ausschließlich durch die Strahlungsaustrittsfläche des Leuchtdiodenchips aus.

Bevorzugt enthält der Leuchtdiodenchip einen epitaktisch gewachsenen Schichtstapel. Der Schichtstapel ist beispielsweise eine Abfolge von epitaktisch gewachsenen Schichten. Bevorzugt umfasst der Schichtstapel wenigstens eine aktive Zone, die zur Erzeugung elektromagnetischer Strahlung geeignet ist.

Dazu kann die aktive Zone beispielsweise einen pn-Übergang, eine Doppelheterostruktur, eine Einfach-Quantentopf- oder besonders bevorzugt eine Mehrfach-Quantentopfstruktur (MQW) aufweisen. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter Anderem Quantentröge, Quantendrähte und Quantenpunkte und jede Kombination dieser Strukturen.

Der Schichtstapel ist besonders bevorzugt eine Abfolge von epitaktisch gewachsenen Schichten, von denen das Aufwachssubstrat nach Abschluss des epitaktischen Wachstums entfernt worden ist. Besonders bevorzugt ist auf die dem ursprünglichen Aufwachssubstrat abgewandte Oberfläche des Schichtstapels ein Träger aufgebracht. Bauteile, die unter Entfernen des Aufwachssubstrats von einer epitaktisch gewachsenen Schichtfolge hergestellt sind, werden oftmals auch mit dem Oberbegriff Dünnfilmschicht-Bauteile bezeichnet.

Ein Grundprinzip eines Dünnfilmschichtbauteils ist beispielsweise in Schnitzer I. et al., "30% external quantum efficiency from surface textured LEDs", Appl. Phys. Lett., Okt 1993, Bd. 63, Seiten 2174 - 2176 beschrieben, deren Offenbarungsgehalt bezüglich des Grundprinzips von Dünnfilmschichtbauteilen hiermit durch Rückbezug aufgenommen wird.

Ein Dünnfilm-Leuchtdiodenchip ist in guter Näherung ein Lambert'scher Oberflächenstrahler und eignet sich von daher besonders gut beispielsweise für die Anwendung in einem Scheinwerfer.

Besonders vorteilhaft ist, dass der Träger verglichen mit dem Aufwachssubstrat relativ frei gewählt werden kann. So kann der Träger hinsichtlich mancher Eigenschaften wie etwa Leitfähigkeit oder Stabilität für das Bauteil besser geeignet sein als verfügbare Aufwachssubstrate, die zur Herstellung hochwertiger, epitaktisch gewachsener Schichtfolgen engen Einschränkungen unterliegen. So muss, um hochwertige epitaktische Schichten zu erhalten, das epitaktisch abgeschiedene Material beispielsweise gitterangepasst zum Aufwachssubstrat sein.

Bevorzugt zeichnet sich der auf dem Schichtstapel aufgebrachte Träger durch einen an den Schichtstapel angepassten thermischen Ausdehnungskoeffizienten aus. Beispielsweise kann der Träger ein Halbleitermaterial wie Germanium, Gallium-Arsenid, Gallium-Nitrid, Silizium-Karbid und andere Materialien wie Saphir, Molybdän oder Metalle enthalten.

Außerdem zeichnet sich der Träger bevorzugt durch eine besonders gute thermische Leitfähigkeit aus, sodass die bei der Erzeugung von elektromagnetischer Strahlung in der aktiven Zone entstehende Wärme zumindest teilweise über den Träger an die Umgebung abgegeben werden kann.

Gemäß einer bevorzugten Ausgestaltung des Leuchtdiodenchips ist zwischen dem aufgebrachten Träger und dem Schichtstapel eine Spiegelschicht angeordnet. Die Spiegelschicht kann beispielsweise einen Bragg-Spiegel oder eine metallhaltige Spiegelschicht umfassen. Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln erreichen.

Besonders bevorzugt weisen beide Leuchtdioden wenigstens einen Leuchtdiodenchip in Dünnfilmbauweise auf.

Gemäß zumindest einer Ausführungsform der Leuchtdiodenanordnung, weist die Leuchtdiodenanordnung einen optischen Detektor auf, der geeignet ist, einen von einem Objekt reflektierten elektromagnetischen Strahlungspuls zu detektieren. Bevorzugt handelt es sich bei dem Strahlungspuls um eine Reflexion eines von einer der Leuchtdioden ausgesandten elektromagnetischen Strahlungspulses. Der Detektor kann sich dabei sowohl innerhalb als auch außerhalb des Gehäuses der Leuchtdiodenanordnung befinden. Bevorzugt ist der Detektor geeignet, das Licht beider Leuchtdioden zu detektieren.

Es ist weiter eine Auswerteschaltung bei der Leuchtdiodenanordnung vorgesehen, die geeignet ist, unter Verwendung des Detektorsignals den Abstand zwischen Objekt und Detektor zu ermitteln. Der Abstand zwischen Detektor und Objekt kann mittels der Auswerteschaltung zum Beispiel aus der Zeit berechnet werden, die zwischen Aussenden des Strahlungspulses und Empfangen des vom Objekt reflektierten Pulses liegt. Es ist darüber hinaus auch möglich, dass die Auswerteschaltung mittels Vergleich des ursprünglichen Pulses mit dem reflektierten Puls den Abstand zum Objekt ermittelt. Dabei kann der Abstand zum Objekt etwa durch Vergleich der Pulsformen bestimmt werden. Bevorzugt ist es auch möglich den Abstand zum Objekt durch Vergleich der Pulsamplituden zu bestimmen.

Gemäß zumindest einer Ausführungsform der Leuchtdiodenanordnung ist es zudem möglich, dass die Leuchtdiodenanordnung zwei Leuchtdioden aufweist, die Licht unterschiedlicher Wellenlänge emittieren können und die Reflexion von Strahlungspulsen beider Leuchtdioden zur Abstandsermittlung herangezogen werden. Auf diese Weise ist es möglich, den Abstand zu einem Objekt besonders genau zu ermitteln. So ist es beispielsweise möglich, dass die reflektierten Pulse der beiden Leuchtdioden mittels unterschiedlicher Auswertealgorithmen ausgewertet werden. Der Abstand zum Objekt für die Reflexion des Pulses einer Leuchtdiode kann etwa mittels Laufzeitunterschieds ermittelt werden. Die Reflexion des Pulses der anderen Leuchtdiode kann zur Ermittlung des Abstands mittels Pulsamplitude oder Pulsformvergleich herangezogen werden.

Insgesamt eignet sich die Leuchtdiodenanordnung besonders gut für den Einsatz in optischen Aufzeichnungsgeräten oder in Geräten zur Abstandsmessung.

Es wird ferner ein optisches Aufzeichnungsgerät mit einer Leuchtdiodenanordnung nach wenigstens einer der oben beschriebenen Ausführungsformen angegeben.

Es wird ein optisches Aufzeichnungsgerät angegeben, das zwei Leuchtdioden aufweist, die antiparallel zueinander geschaltet sind. Das heißt, wenn an der Verschaltung der Leuchtdioden eine gemeinsame äußere Spannung anliegt, so ist eine der Leuchtdioden in Durchlassrichtung und die andere Leuchtdiode in Sperrrichtung geschaltet.

Weiter ist eine Stromversorgung vorgesehen, die geeignet ist, die Leuchtdioden unabhängig voneinander in Durchlassrichtung zu bestromen. Die Stromversorgung ist dazu geeignet, die Leuchtdioden beispielsweise abwechselnd in Durchlassrichtung zu bestromen. Die Stromversorgung kann jedoch auch geeignet sein, beide Leuchtdioden gleichzeitig in Durchlassrichtung zu bestromen. Darüber hinaus kann die Stromversorgung beispielsweise geeignet sein, eine der Leuchtdioden im Dauerbetrieb in Durchlassrichtung zu bestromen, während die zweite Leuchtdiode zu vorgegebenen Zeiten für vorgegebene Zeitspannen in Durchlassrichtung bestromt wird. Auch kann es möglich sein, dass beide Leuchtdioden abwechselnd dauer- oder pulsbetrieben werden.

Es wird also ein optisches Aufzeichnungsgerät angegeben, aufweisend zwei antiparallel zueinander geschaltete Leuchtdioden und eine Stromversorgung, die geeignet ist, die Leuchtdioden unabhängig voneinander in Durchlassrichtung zu bestromen.

Bevorzugt sind die Leuchtdioden in einem gemeinsamen Gehäuse angeordnet. Die Stromversorgung der Leuchtdioden kann beispielsweise außerhalb des Gehäuses angeordnet sein. Das Gehäuse ist bevorzugt oberflächenmontierbar ausgestaltet. Auf diese Weise kann den Leuchtdioden in einer Hauptabstrahlrichtung der Leuchtdioden besonders platzsparend beispielsweise wenigstens ein optisches Element nachgeordnet sein. Das optische Element kann auf Teilen des Gehäuses befestig sein. Bei dem optischen Element kann es sich um eine refraktive, diffraktive, holographische oder auch eine reflektive Optik handeln. Weiter kann das optische Element für mehrere Leuchtdioden optimiert sein. Das heißt, das optische Element ist in diesem Fall derart ausgebildet, dass es für alle Leuchtdioden als optisches Element wirkt. Dazu kann beispielsweise die Lichtaustrittsfläche des optischen Elements entsprechend ausgebildet sein.

Die Leuchtdioden sind bevorzugt von einer gemeinsamen Vergussmasse zumindest teilweise umgeben. Die Vergussmasse ist bevorzugt für die von den Leuchtdioden emittierte elektromagnetische Strahlung zumindest teilweise transparent. Die Vergussmasse kann beispielsweise ein optisches Element bilden. Die optischen Eigenschaften des optischen Elements sind beispielsweise durch die Wahl des Brechungsindex und die Form der Grenzflächen der Vergussmasse, durch welche die von den Leuchtdioden erzeugte elektromagnetische Strahlung die Vergussmasse verlässt, definiert einstellbar. Es ist auch möglich, dass ein separates optisches Element auf zumindest Teile der Vergussmasse aufgebracht ist.

Es sind die Leuchtdioden geeignet, Licht unterschiedlicher Wellenlänge zu emittieren. Eine der Leuchtdioden ist geeignet, Licht im roten Spektralbereich zu erzeugen, während die andere Leuchtdiode geeignet ist, Licht im blauen Spektralbereich zu erzeugen.

Bevorzugt sind die Leuchtdioden unterschiedlich dimensioniert, d. h. die Leuchtdioden können sich in Kenngrößen wie ihrer elektrischen Leistungsaufnahme oder ihrer relativen Helligkeit unterscheiden.

Das optische Aufzeichnungsgerät macht sich dabei unter Anderem die Idee zunutze, dass durch die Anordnung zweier unterschiedlicher Leuchtdioden in einem gemeinsamen Gehäuse auf besonders Platz sparende Weise eine besonders vielseitig einsetzbare Anordnung von Leuchtdioden in ein optisches Aufzeichnungsgerät integriert werden kann. Ferner ermöglicht die räumlich nahe Anordnung der Leuchtdioden, dass die Leuchtdioden ein gemeinsames optisches Element nutzen können.

Es ist ein Lumineszenz-Konversionsmaterial vorgesehen, das geeignet ist, die von wenigstens einer der Leuchtdioden emittierte elektromagnetische Strahlung teilweise Wellenlängen zu konvertieren. Das heißt, wenigstens einer der Leuchtdioden ist in Abstrahlrichtung ein Lumineszenz-Konversionsmaterial nachgeordnet, welches einen Teil der vom Leuchtdiodenchip emittierten Strahlung absorbiert und daraufhin Strahlung einer anderen Wellenlänge emittiert. Das Lumineszenz-Konversionsmaterial emittiert Strahlung einer größeren Wellenlänge als die Wellenlänge der Strahlung, die ursprünglich von der Leuchtdiode emittiert wurde. Eine resultierende Strahlung ergibt sich durch Mischung des wellenlängenkonvertierten Anteils der Strahlung mit der von der Leuchtdiode ursprünglich ausgesandten Strahlung.

In einer weiteren Ausführungsform kann das Lumineszenz-Konversionsmaterial beispielsweise in einer dünnen Schicht auf die Strahlungsauskoppelfläche wenigstens einer der Leuchtdioden aufgebracht sein. Es ist aber auch möglich, dass lediglich auf eine der Leuchtdioden ein Lumineszenz-Konversionsmaterial in einer dünnen Schicht aufgebracht ist. Weiter ist es möglich, dass auf die beiden Leuchtdioden jeweils ein Lumineszenz-Konversionsmaterial aufgebracht ist, das unterschiedliche Leuchtstoffe enthalten kann. Die Leuchtstoffe können dabei der jeweiligen elektromagnetischen Strahlung, die von der Leuchtdiode erzeugt wird, angepasst sein.

Bevorzugt kann auch die gemeinsame Vergussmasse das Lumineszenz-Konversionsmaterial enthalten. Besonders bevorzugt ist eine der Leuchtdioden geeignet, elektromagnetische Strahlung einer Wellenlänge zu emittieren, die die Vergussmasse weitgehend ungehindert durchdringen kann. Weitgehend ungehindert heißt in diesem Zusammenhang, dass die von dieser Leuchtdiode abgegebene elektromagnetische Strahlung durch das in der Vergussmasse vorhandene Lumineszenz-Konversionsmaterial nicht oder nur unwesentlich wellenlängenkonvertiert wird. Die Strahlung tritt also mit der gleichen Wellenlänge aus der Vergussmasse aus, mit der sie von der Leuchtdiode emittiert worden ist, ohne dass ein wesentlicher Anteil dieser Strahlung von Bestandteilen der Vergussmasse absorbiert wird. Die elektromagnetische Strahlung der anderen Leuchtdiode wird dann vorzugsweise zumindest teilweise wellenlängenkonvertiert.

In einer weiteren Ausführungsform des optischen Aufzeichnungsgeräts ist ein optischer Detektor vorgesehen. Der optische Detektor ist geeignet, einen von einem Objekt reflektierten elektromagnetischen Strahlungspuls zu detektieren. Bevorzugt ist der Detektor geeignet, einen Strahlungspuls zu detektieren, der der reflektierte Puls eines von einer der Leuchtdioden abgegebenen Strahlungspulses ist. Der Detektor kann dazu in seiner Empfindlichkeit der Wellenlänge der von der Leuchtdiode ausgesandten elektromagnetischen Strahlung angepasst sein, d. h. der Detektor ist bevorzugt in dem Wellenlängenbereich der von der Leuchtdiode ausgesandten elektromagnetischen Strahlung besonders empfindlich. Bevorzugt ist dazu eine der Leuchtdioden geeignet, Strahlungspulse im infraroten Spektralbereich zu erzeugen. Bevorzugt ist der Detektor im infraroten Strahlungsbereich besonders empfindlich.

Es ist weiter eine Auswerteschaltung vorgesehen, die geeignet ist, unter Verwendung des Detektorsignals den Abstand zwischen Objekt und Detektor zu ermitteln. Der Abstand zwischen Detektor und Objekt kann mittels der Auswerteschaltung zum Beispiel aus der Zeit berechnet werden, die zwischen Aussenden des Strahlungspulses und Empfangen des vom Objekt reflektierten Pulses liegt. Es ist darüber hinaus auch möglich, dass die Auswerteschaltung mittels Vergleich des ursprünglichen Pulses mit dem reflektierten Puls den Abstand zum Objekt ermittelt. Dabei kann der Abstand zum Objekt etwa durch Vergleich der Pulsformen bestimmt werden. Bevorzugt ist es auch möglich den Abstand zum Objekt durch Vergleich der Pulsamplituden zu bestimmen.

Der derart bestimmte Abstand zwischen Objekt und Detektor kann in einem Autofokus-System des optischen Aufzeichnungsgerätes genutzt werden.

In einer weiteren Ausführungsform des optischen Aufzeichnungsgeräts ist wenigstens eine der Leuchtdioden geeignet, Blitzlicht mit einer Beleuchtungsdauer von bis zu 500 ms, typischerweise 300 ms zu erzeugen. Die Beleuchtungsdauer kann jedoch auch geringer sein und beispielsweise zwischen 100 ms und 200 ms betragen. Bevorzugt ist im optischen Aufzeichnungsgerät eine Vorrichtung vorgesehen, die geeignet ist, wenigstens eine der Leuchtdioden für diese Zeitspannen zu bestromen. Bei der Vorrichtung kann es sich um eine Pulsweitenmodulationsschaltung handeln.

Besonders bevorzugt sind beide Leuchtdioden geeignet, in der beschriebenen Weise Blitzlicht zu erzeugen. Die Vorrichtung kann dann für beide Leuchtdioden zur Pulserzeugung dienen. Dabei ist es insbesondere möglich, dass sich das von wenigstens einer der Leuchtdioden emittierte Licht mit dem wellenlängenkonvertierten Anteil der Strahlung zu weißem Licht mischt. Besonders bevorzugt sind auf diese Weise beide Leuchtdioden geeignet, weißes Blitzlicht zu erzeugen.

In einer weiteren Ausführungsform des optischen Aufzeichnungsgeräts lässt sich die Beleuchtungsstärke des Blitzlichts definiert einstellen, d. h. die Vorrichtung zur pulsweisen Bestromung ist beispielsweise geeignet, die Pulsdauer an gemessene Größen anzupassen. Die Pulsdauer wird also bevorzugt durch eine Steuergröße bestimmt. Bei der Steuergröße handelt es sich bevorzugt um einen gemessen Wert, beispielsweise die Umgebungshelligkeit. So reicht es beispielsweise bei hoher Umgebungshelligkeit aus, Blitzlicht geringerer Beleuchtungsstärke zu erzeugen. Die Pulslänge des Blitzlichts kann dann beispielsweise abgesenkt werden. Die Pulslänge des Blitzlichts kann aber beispielsweise auch der Belichtungsdauer des optischen Aufzeichnungsgeräts angepasst sein.

In einer weiteren Ausführungsform des optischen Aufzeichnungsgeräts ist wenigstens eine Pulsweitenmodulationsschaltung vorgesehen, die geeignet ist, wenigstens eine der Leuchtdioden gepulst zu betreiben. Mittels der Pulsweitenmodulationsschaltung ist es beispielsweise möglich, die Lichtstärke der Leuchtdiode beim Betrieb zu regulieren. Je kürzer die Anschaltzeiten der Leuchtdiode im Vergleich zu den Einschaltzeiten sind, desto heller erscheint das Licht der Leuchtdiode. Auf diese Weise ist es beispielsweise möglich, wenigstens eine der Leuchtdioden als dimmbare Lichtquelle zu betreiben.

In einer weiteren Ausführungsform des optischen Aufzeichnungsgeräts ist eine Vorrichtung vorgesehen, die geeignet ist, wenigstens eine der Leuchtdioden synchron zu einer durch das optische Aufzeichnungsgerät gesteuerten Abfolge von Bildaufzeichnungen zu bestromen. Bei der Vorrichtung kann es sich beispielsweise um eine Pulsweitenmodulationsschaltung handeln. Bevorzugt steuert die Vorrichtung sowohl das Blitzlicht, als auch die Abfolge der Bildaufzeichnungen. So kann etwa bei der Aufzeichnung einer Videosequenz durch das optische Aufzeichnungsgerät jedes Einzelbild der Videoaufzeichnung mit einem dazugehörigen Lichtblitz beleuchtet werden. Aufgrund der Trägheit der Verarbeitung von visuellen Signalen erscheint die Sequenz dem Betrachter als kontinuierlich ausgeleuchtet. Die genaue Abstimmung von Beleuchtungspuls zu Bildaufzeichnung hat aber gegenüber einem Dauerbetrieb der Leuchtdiode den Vorteil, besonders energiesparend zu sein. Außerdem reduziert sich im Pulsbetrieb der Leuchtdiode gegenüber dem Dauerbetrieb die Wärmeentwicklung durch das Betreiben der Leuchtdiode. Dies reduziert vorteilhaft den Aufwand, der für eine ausreichende Kühlung der Leuchtdiode notwendig ist.

In einer weiteren Ausführungsform des optischen Aufzeichnungsgeräts handelt es sich bei dem optischen Aufzeichnungsgerät um eines der folgenden Geräte: Foto-Handy, Digitalkamera, Videokamera, Fotoapparat. Die Strom sparende und Platz sparende Anordnung der Leuchtdioden ist in diesen Geräten besonders vorteilhaft.

Es wird ferner ein Verfahren zum gepulsten Betreiben wenigstens einer Leuchtdiode angegeben, wobei die Leuchtdiode synchron zu einer durch ein optisches Aufzeichnungsgerät gesteuerten Abfolge von Bildaufzeichnungen bestromt wird. Bevorzugt wird die Bestromung der Leuchtdiode dabei vom gleichen Mechanismus gesteuert, wie die Abfolge der Bildaufzeichnungen. Das heißt, das optische Aufzeichnungsgerät steuert bevorzugt sowohl die Bestromung der Leuchtdiode als auch die Abfolge von Bildaufzeichnungen. Die Leuchtdiode kann dabei sowohl in einem Gehäuse des optischen Aufzeichnungsgeräts integriert sein, als auch außerhalb als externe Beleuchtungsquelle angeordnet sein. Es kann insbesondere eine Vielzahl von Leuchtdioden auf diese Weise vom optischen Aufzeichnungsgerät synchron zur Bildaufzeichnung bestromt werden. Wie oben beschrieben, eignet sich das synchrone Betreiben der Leuchtdioden besonders für Videoaufzeichnungen. Beim Einsatz mehrere Leuchtdioden kann die Videosequenz dann vorteilhaft aus verschiedenen Richtungen ausgeleuchtet werden.

Darüber hinaus ist es möglich, dass der Leuchtdiode eine weitere Leuchtdiode als ESD-Schutz antiparallel geschaltet ist. Es ist aber auch möglich, dass der Leuchtdiode beispielsweise eine Zener-Diode oder ein elektrischer Widerstand als ESD-Schutz parallel geschaltet ist.

Im Folgenden wird die Leuchtdiodenanordnung anhand von Ausführungsbeispielen und den dazugehörigen Figuren näher erläutert.
Figur 1 zeigt ein beispielhaftes Ersatzschaltbild eines ersten Ausführungsbeispiels der hier beschriebenen Leuchtdiodenanordnung.
Figur 2 zeigt ein beispielhaftes Ersatzschaltbild eines zweiten Ausführungsbeispiels der hier beschriebenen Leuchtdiodenanordnung.
Figur 3 zeigt einen schematisch dargestellten Querschnitt durch ein Ausführungsbeispiel der hier beschriebenen Leuchtdiodenanordnung.
Figur 4A zeigt beispielhaft ein Strom-Zeit Diagramm für ein Ausführungsbeispiel der Leuchtdiodenanordnung.
Figur 4B zeigt beispielhaft ein Strom-Zeit Diagramm für ein Ausführungsbeispiel der Leuchtdiodenanordnung.
Figur 5 zeigt einen schematisch dargestellten Querschnitt durch ein Ausführungsbeispiel der hier beschriebenen Leuchtdiodenanordnung im hier beschrieben optischen Aufzeichnungsgerät.

In den Ausführungsbeispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

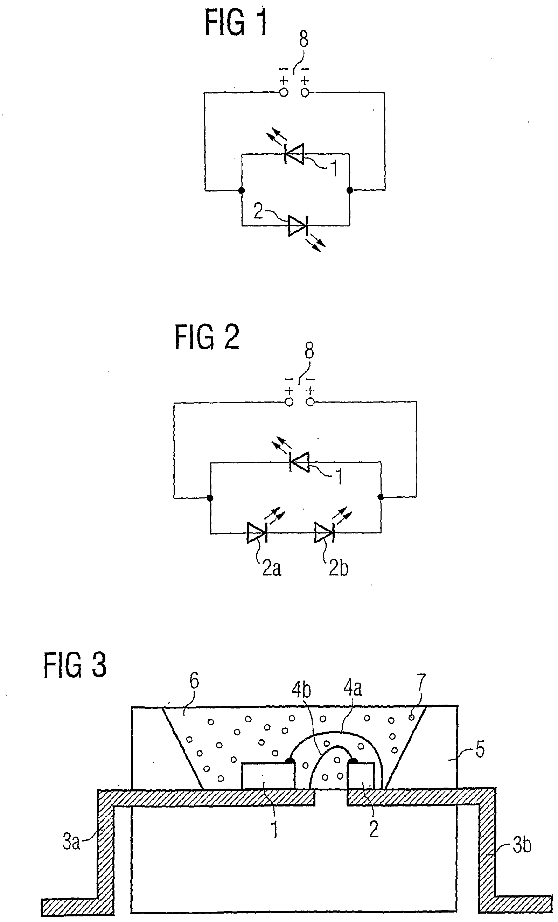

Figur 1 zeigt ein Ersatzschaltbild eines ersten Ausführungsbeispiels der hier beschriebenen Leuchtdiodenanordnung. Die Leuchtdiodenanordnung weist eine erste Leuchtdiode 1 und eine zweite Leuchtdiode 2 auf, die antiparallel zueinander geschaltet sind. Die erste Leuchtdiode 1 ist zur Erzeugung von Licht mit einer Wellenlänge *λ*₁ geeignet, während die zweite Leuchtdiode zur Erzeugung von Licht mit einer Wellenlänge *λ*₂ geeignet ist. Die antiparallel zueinander verschalteten Leuchtdioden werden durch eine Pulsweiten-Modulationsschaltung 8 mit Strom wechselnder Richtung bestromt.

Dabei wird die erste Leuchtdiode 1 beispielsweise für eine Zeitspanne *t*₁ mit einem Strom der Stärke *I*₁ in Durchlassrichtung bestromt, so dass sie für die Zeitspanne *t*₁ elektromagnetische Strahlung der Wellenlänge *λ*₁ emittiert.

Die zweite Leuchtdiode 2 wird für eine Zeitspanne *t*₂ mit einem Strom *I*₂ in Durchlassrichtung bestromt, so dass sie für die Zeitspanne *t*₂ elektromagnetische Strahlung der Wellenlänge *λ*₂ emittiert.

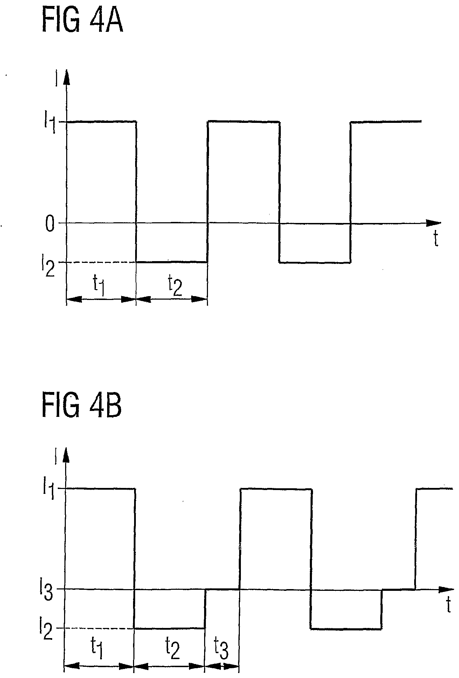

Figur 4A zeigt dazu ein beispielhaftes Storm-Zeit-Diagramm der Leuchtdiodenanordnung, bei der jeweils für eine Zeitspanne *t*₁ der Strom *I*₁ und für eine Zeitspanne *t*₂ der Strom *I*₂ fließt.

Die Frequenz der Pulsweiten-Modulationsschaltung ist durch ¹/_{(*t*1+*t*2)} gegeben. Bevorzugt beträgt die Frequenz der Pulsweiten-Modulationsschaltung größer gleich 100 Hz. Für das menschliche Auge sind die beiden Wellenlängen *λ*₁ und *λ*₂ daher nicht getrennt wahrnehmbar, sondern die beiden Wellenlängen vermischen zu einem Licht mit Anteilen der Wellenlängen *λ*₁ und *λ*₂. Die Zeitspannen *t*₁ und *t*₂ können dabei sowohl gleich lang sein, als auch verschiedene Längen aufweisen. Ist beispielsweise *t*₁ *> t*₂*,* so weist das von der Leuchtdiodenanordnung abgestrahlte Licht einen größeren Anteil der Wellenlänge *λ*₁ auf.

Darüber hinaus ist es zudem möglich, dass wie Figur 4B zeigt für eine bestimmte Todzeit *t*₃ kein Strom, das heißt *I*₃ = 0, durch die Leuchtdiodenanordnung fließt. Auf diese Weise, kann die Strahlleistung der Leuchtdiodenanordnung reguliert werden. Je größer die Zeitspanne *t*₃, bei der kein Strom durch die Anordnung fließt, relativ zu *t*₁ und *t*₂ ist, desto weniger hell erscheint das von der Anordnung abgestrahlte Licht. Wichtig ist dabei wiederum, dass die Zeitspannen klein genug sind, so dass der menschliche Betrachter kein Flackern des abgestrahlten Lichts bemerkt.

Figur 2 zeigt ein Ersatzschaltbild eines zweiten Ausführungsbeispiels der Leuchtdiodenanordnung. Hier sind zwei Leuchtdioden 2a und 2b in Reihe zueinander geschaltet, die erste Leuchtdiode 1 ist zu dieser Reihenschaltung antiparallel geschaltet. Entsprechend werden die Leuchtdioden 2a und 2b für eine Zeitspanne *t*₂ gleichzeitig in Durchlassrichtung betrieben und emittieren dabei elektromagnetische Strahlung der Wellenlängen *λ*_{2*a*} und *λ*_{2*b*}. Auf diese Weise kann der von der Leuchtdiodenanordnung emittierten elektromagnetischen Strahlung ein weiterer Lichtanteil beigemengt werden.

Figur 3 zeigt einen schematisch dargestellten Querschnitt durch ein Ausführungsbeispiel der Leuchtdiodenanordnung. Dabei ist die erste Leuchtdiode 1 ein Leuchtdiodenchip, der geeignet ist, elektromagnetische Strahlung im Wellenlängenbereich zwischen 420 nm und 470 nm zu emittieren. Bevorzugt liegt das Maximum der emittierten Strahlung bei 450 nm. Beispielsweise kann es sich bei der Leuchtdiode 1 um einen einzelnen Leuchtdiodenchip handeln.

Die erste Leuchtdiode 1 kann beispielsweise mit einem Strom von *I*₁ gleich 350 mA in Durchlassrichtung betrieben werden. Bevorzugt wird er für eine Zeitspanne *t*₁ gleich 50 ms in Durchlassrichtung betrieben. Die Leuchtdiode 1 ist auf ein erstes Anschlussteil 3a gebondet und über einen Wirebonding-Kontakt 4a mit dem zweiten Anschlussteil 3b kontaktiert. Antiparallel zu ihr ist die zweite Leuchtdiode 2 geschaltet, die beispielsweise auf das zweite Anschlussteil 3b gebondet ist und mit dem ersten Anschlussteil 3a über einen Wirebonding-Kontakt 4b kontaktiert ist. Beispielsweise kann es sich bei der zweiten Leuchtdiode 2 um einen einzelnen Leuchtdiodenchip handeln.

Die zweite Leuchtdiode 2 ist geeignet, elektromagnetische Strahlung im roten Spektralbereich zu emittieren. Das Maximum der von der zweiten Leuchtdiode 2 emittierten Strahlung liegt zwischen 600 nm und 750 nm. Besonders bevorzugt wird die zweite Leuchtdiode 2 mit einem Strom der Stromstärke *I*₂ zwischen 1 mA und 30 mA für eine Zeitspanne *t*₂ in Durchlassrichtung bestromt. Die Zeitspanne beträgt dabei bevorzugt circa 50 ms. Beide Leuchtdioden 1 und 2 sind in der Ausnehmung eines Grundkörpers 5 angeordnet und von einer gemeinsamen Vergussmasse 6 umgeben.

Bevorzugt enthält die Vergussmasse 6 ein Epoxid-Gießharz oder Silikon, das für die von den Leuchtdioden 1 und 2 emittierte elektromagnetische Strahlung transparent ist. Weiter enthält die Vergussmasse 6 bevorzugt ein Lumineszenz-Konversionsmaterial 7, das geeignet ist, einen Teil des von der Leuchtdiode 1 emittierten blauen Lichts in Licht des gelben Spektralbereichs zu konvertieren. Das gelbe Licht liegt dabei bevorzugt in einem Spektralbereich zwischen 530 nm und 580 nm. Besonders bevorzugt liegt das Maximum der Wellenlänge des gelben Lichts bei circa 565 nm.

Das blaue Licht der Leuchtdiode 1 und das gelbe Licht des Lumineszenz-Konversionsmaterials mischen sich zu weißem Licht. Die Farbkoordinaten des weißen Lichts sind dabei beispielsweise durch *Cₓ* gleich 0.32 und *C_{y}* gleich 0.31 nach CIE 1931 gegeben. Die Farbtemperatur liegt bevorzugt bei circa 6500 K.

Die Leuchtdiodenanordnung emittiert daher für eine Zeitspanne *t*₁ weißes Licht und für eine Zeitspanne *t*₂ rotes Licht. Der Anteil des roten Lichts kann dabei zum einen durch eine Verlängerung der Zeitspanne *t*₂ gegenüber *t*₁ oder zum anderen durch eine Erhöhung der Stromstärke *I*₂, mit der die zweite Leuchtdiode 2 betrieben wird, erhöht werden. Auch ist es möglich, gemäß Figur 2 weitere rotes Licht abstrahlende Leuchtdioden 2b in Reihe zu schalten. Das rote Licht der zweiten Leuchtdiode 2 durchdringt die Vergussmasse bevorzugt ohne vom Lumineszenz-Konversionsmaterial wellenlängenkonvertiert zu werden.

Es stellen die antiparallel zueinander geschalteten Leuchtdioden 1, 2 einen gegenseitigen ESD-Schutz in Sperrrichtung für einander dar. Beispielsweise ist die Leuchtdiodenanordnung auf diese Weise bis 2 kV nach JESD 22-A114-B ESD-sicher.

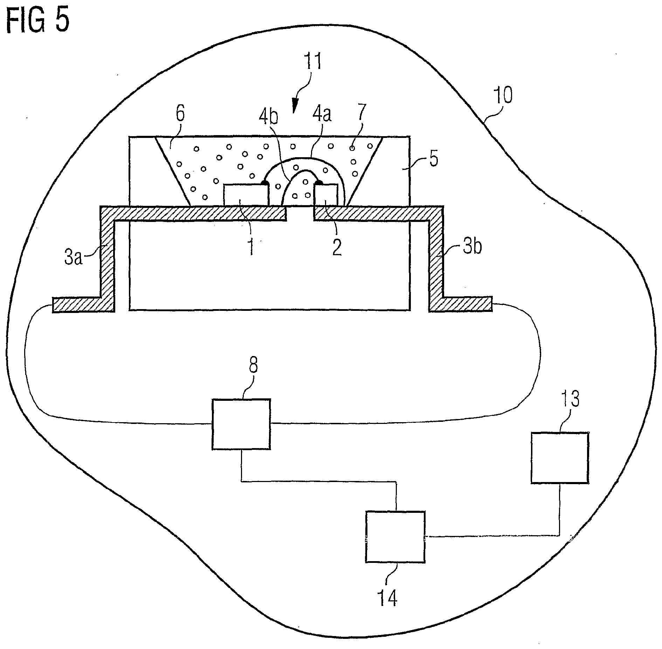

Figur 5 zeigt einen schematisch dargestellten Querschnitt durch ein Ausführungsbeispiel einer Leuchtdiodenanordnung 11 in einem optischen Aufzeichnungsgerät 10.

Die erste Leuchtdiode 1 ist geeignet, elektromagnetische Strahlung im ultraviolett-blauen Spektralbereich zu emittieren. Sie ist geeignet, elektromagnetische Strahlung zwischen 420 nm und 470 nm zu emittieren. Bevorzugt liegt das Maximum der emittierten Strahlung bei 450 nm. Die erste Leuchtdiode 1 ist beispielsweise geeignet mit einem konstanten Strom von ca. 350 mA in Durchlassrichtung bestromt zu werden. Die zweite Leuchtdiode 2 kann baugleich mit der ersten Leuchtdiode 1 sein. Es ist aber auch möglich, dass die zweite Leuchtdiode 2 beispielsweise kleiner dimensioniert ist als die erste Leuchtdiode 1. Sie kann beispielsweise mit einem Strom zwischen 1 und 50 mA in Durchlassrichtung betrieben werden.

Je nach Funktion der Leuchtdiode 2 kann der Wellenlängenbereich, in dem die Leuchtdiode 2 geeignet ist, elektromagnetische Strahlung zu emittieren, angepasst sein. So ist die Leuchtdiode 2 geeignet, elektromagnetische Strahlung im roten Spektralbereich zu emittieren.

Beide Leuchtdioden 1, 2 sind bevorzugt in einem gemeinsamen Gehäuse angeordnet. Dazu sind beide Leuchtdioden 1, 2 beispielsweise in der Ausnehmung eines Grundkörpers 5 angeordnet und von einer gemeinsamen Vergussmasse 6 umgeben. Bevorzugt enthält die Vergussmasse 6 ein Epoxid-Gießharz oder Silikon, das für die von den Leuchtdioden 1, 2 emittierte elektromagnetische Strahlung transparent ist. Weiter enthält die Vergussmasse 6 bevorzugt ein Lumineszenz-Konversionsmaterial 7, das geeignet ist, einen Teil des beispielsweise von der Leuchtdiode 1 emittierten blauen Lichts in Licht des gelben Spektralbereichs zu konvertieren. Das gelbe Licht liegt dabei in einem Spektralbereich zwischen 530 nm und 580 nm. Besonders bevorzugt liegt das Maximum der Wellenlänge des gelben Lichts bei ca. 565 nm. Das blaue Licht der Leuchtdiode 1 und das gelbe Licht des Lumineszenz-Konversionsmaterials 7 mischen sich zu weißem Licht. Die Leuchtdioden 1, 2 sind beispielsweise durch die Anschlussteile 3a, 3b von außerhalb des Gehäuses kontaktierbar und mittels Wire-Bonding 4a, 4b innerhalb des Gehäuses antiparallel zueinander verschaltet. Beispielsweise handelt es sich bei den Leuchtdioden 1, 2 jeweils um einzelnen Leuchtdiodenchips. Weiter ist es möglich, dass mehrere Leuchtdiodenchips 1 - beispielsweise vier oder fünf Leuchtdiodenchips - in einem gemeinsamen Gehäuse angeordnet sind. Zu den Leuchtdiodenchips 1 ist die Leuchtdiode 2 dann antiparallel geschaltet. Die Leuchtdiodenchips 1 können zum Beispiel auf einem Keramikträger angeordnet sein. Bei den Leuchtdiodenchips 1 kann es sich zum Beispiel um zwei grünes Licht, einen blaues Licht und einen rotes Licht emittierenden Leuchtdiodenchip handeln. Beim gemeinsamen Betrieb sind die Leuchtdiodenchips 1 dann geeignet, weißes Licht zu erzeugen. In einem Ausführungsbeispiel des optischen Aufzeichnungsgeräts kann beispielsweise die Leuchtdiode 2 als Vorblitz eingesetzt werden, um den Rote-Augen-Effekt beim Fotografieren zu reduzieren. In einer nicht erfindungsgemäßen Abwandlung des optischen Aufzeichnungsgeräts ist die zweite Leuchtdiode 2 geeignet, Licht im blauen Spektralbereich zu emittieren, sodass sich die emittierte elektromagnetische Strahlung mit der vom Lumineszenz-Konversionsmaterial 7 abgegebenen Strahlung zu weißem Licht mischt.

In einem weiteren Ausführungsbeispiel ist zusätzlich eine Pulsweitenmodulationsschaltung 8 vorgesehen, über die beispielsweise die zweite Leuchtdiode 2 in Durchlassrichtung angesteuert werden kann. Auf diese Weise ist es zudem möglich, die zweite Leuchtdiode 2 als dimmbare Beleuchtungsquelle im Sinne einer dimmbaren Taschenlampe zu nutzen. Besonders bevorzugt wird die zweite Leuchtdiode 2 dabei mit Strömen zwischen 25 und 35 mA betrieben.

In einem weiteren Ausführungsbeispiel ist es möglich, die zweite Leuchtdiode 2 sowohl als Vorblitz als auch als dimmbare Taschenlampe einzusetzen.

Die Platz sparende Anordnung der Leuchtdioden 1, 2 im optischen Aufzeichnungsgerät sowie die Strom sparende zweite Leuchtdiode 2 sind dabei besonders vorteilhaft in kompakten Geräten wie Handys oder Digitalkameras einsetzbar.

In einem weiteren Ausführungsbeispiel des optischen Aufzeichnungsgeräts ist eine Vorrichtung vorgesehen, mit der es möglich ist, die erste Leuchtdiode 1 als Blitz zu betreiben. Bei der Vorrichtung kann es sich beispielsweise um eine Pulsweitenmodulationsschaltung 8 handeln. Die Beleuchtungsdauer kann dabei bevorzugt an die Umgebungshelligkeit angepasst werden. Dazu ist es beispielsweise möglich, dass mittels eines optischen Detektors 13 die Umgebungshelligkeit vor dem Auslösen des Blitzes ermittelt wird und die Beleuchtungsdauer dem ermittelten Wert angepasst wird. Bei dem optischen Detektor 13 handelt es sich zum Beispiel um eine Photodiode oder einen Phototransistor.

In einer nicht erfindungsgemäßen Abwandlung des optischen Aufzeichnungsgeräts ist beispielsweise die zweite Leuchtdiode 2 geeignet, Licht im infraroten Spektralbereich zu emittieren. Zusätzlich weist das optische Aufzeichnungsgerät einen Detektor 13 auf, der geeignet ist, das von beispielsweise einem zu fotografierenden Objekt reflektierte Licht der zweiten Leuchtdiode 2 zu detektieren. Mit Hilfe einer wie im allgemeinen Teil der Beschreibung angegebenen Auswerteschaltung 14 kann dann der Abstand zwischen Objekt und Detektor 13 und damit der Abstand zwischen Objekt und Aufzeichnungsgerät bestimmt werden. Die so gewonnene Abstandsinformation kann beispielsweise genutzt werden, um eine Optik so einzustellen, dass ein scharfes Bild des Objekts aufgenommen werden kann.

In einer weiteren nicht erfindungsgemäßen Abwandlung ist zumindest eine der Leuchtdioden 1, 2 geeignet, elektromagnetische Strahlung im infraroten Spektralbereich zu erzeugen. Das Licht dieser Leuchtdiode kann dann zum Beispiel als Blitzlicht oder Dauerbeleuchtung für einen Nachtsichtmodus des optischen Aufzeichnungsgeräts Verwendung finden. Das heißt, dass optische Aufzeichnungsgerät ist in diesem Fall geeignet, die reflektierte elektromagnetische Strahlung der Leuchtdioden im infraroten Frequenzbereich zu empfangen und in Licht im sichtbaren Frequenzbereich umzuwandeln.

Es stellen die Leuchtdioden 1, 2 einen gegenseitigen ESD-Schutz in Sperrrichtung dar. Bevorzugt ist die Anordnung der Leuchtdioden ESD-sicher bis 2 kV nach JESD22-A114-B.

## Patentansprüche

1. Leuchtdiodenanordnung, aufweisend
zwei Leuchtdioden (1, 2), die antiparallel zueinander geschaltet sind, und eine Vorrichtung (8), die die Leuchtdioden mit Strom wechselnder Richtung bestromt wobei
- die Leuchtdioden einen gegenseitigen Schutz gegen elektrostatische Entladung bilden, und
- ein Lumineszenz-Konversionsmaterial (7) die von einer der Leuchtdioden (1) emittierte elektromagnetische Strahlung teilweise wellenlängenkonvertiert, sodass sich die elektromagnetische Strahlung dieser Leuchtdiode (1) mit dem wellenlängenkonvertierten Anteil ihrer Strahlung zu weißem Licht mischt,
**dadurch gekennzeichnet, dass**
- die wellenlängenkonvertierte Leuchtdiode (1) elektromagnetische Strahlung mit einer Wellenlänge zwischen 420 nm und 470 nm emittiert und das Lumineszenz-Konversionsmaterial (7) einen Teil dieser Strahlung zu elektromagnetischer Strahlung mit einer Wellenlänge zwischen 530 nm und 580 nm konvertiert, und
- die andere der Leuchtdioden (2) elektromagnetische Strahlung im roten Spektralbereich mit einer Wellenlänge zwischen 600 nm und 750 nm emittiert, sodass ein Farbwiedergabeindex erhöht ist.

2. Leuchtdiodenanordnung nach Anspruch 1,
bei der die Vorrichtung (8) die Leuchtdioden für vorgebbare Zeitspannen mit Strom einer vorgebbaren Richtung und Stärke bestromt.

3. Leuchtdiodenanordnung nach Anspruch 1 oder 2,
bei der die Vorrichtung (8) eine Pulsweiten-Modulationsschaltung ist.

4. Leuchtdiodenanordnung nach einem der vorhergehenden Ansprüche,
bei der die Leuchtdioden (1, 2) in einem gemeinsamen Gehäuse (5) angeordnet sind.

5. Leuchtdiodenanordnung nach einem der vorhergehenden Ansprüche,
bei der die Leuchtdioden (1, 2) von einer Vergussmasse (6) umgeben sind.

6. Leuchtdiodenanordnung nach dem vorhergehenden Anspruch,
bei der eine der Leuchtdioden (2) geeignet ist, elektromagnetische Strahlung einer Wellenlänge zu emittieren, die die Vergussmasse (6) weitgehend ungehindert durchdringt.

7. Leuchtdiodenanordnung nach einem der vorhergehenden Ansprüche,
bei der zu wenigstens einer der Leuchtdioden (2a) wenigstens eine weitere Leuchtdiode (2b) in Reihe geschaltet ist.

8. Leuchtdiodenanordnung nach einem der vorhergehenden Ansprüche,
bei der zumindest eine der Leuchtdioden (1, 2) einen Leuchtdiodenchip in Dünnfilmbauweise aufweist.

9. Optisches Aufzeichnungsgerät, aufweisend eine Leuchtdiodenanordnung (11) nach einem der vorherigen Ansprüche.

## Claims

1. A light-emitting diode arrangement comprising two light-emitting diodes (1, 2) which are connected antiparallel to one another, and a device (8) which supplies current to the light-emitting diodes with current changing direction, wherein
- the light-emitting diodes form a mutual protection against electrostatic discharge, and
- a luminescence conversion material (7) partially wavelength-converts the electromagnetic radiation emitted by one of the light-emitting diodes (1) so that the electromagnetic radiation of this light-emitting diode (1) mixes with the wavelength-converted portion of its radiation to form white light,
**characterized in that**
- the wavelength-converted light-emitting diode (1) emits electromagnetic radiation having a wavelength between 420 nm and 470 nm, and the luminescence conversion material (7) converts a portion of said radiation into electromagnetic radiation having a wavelength between 530 nm and 580 nm, and
- the other of the light-emitting diodes (2) emits electromagnetic radiation in the red spectral range with a wavelength between 600 nm and 750 nm so that a color rendering index is increased.

2. The light-emitting diode arrangement according to claim 1, wherein the device (8) supplies the light-emitting diodes with current with a predefinable direction and strength for predefinable time periods.

3. The light-emitting diode arrangement according to claim 1 or 2,
wherein the device (8) is a pulse width modulation circuit.

4. The light-emitting diode arrangement according to one of the preceding claims,
wherein the light-emitting diodes (1, 2) are arranged in a common housing (5).

5. The light-emitting diode arrangement according to one of the preceding claims,
wherein the light-emitting diodes (1, 2) are surrounded by a casting compound (6).

6. The light-emitting diode arrangement according to the preceding claim,
wherein one of the light-emitting diodes (2) is suitable for emitting electromagnetic radiation of a wavelength which penetrates the casting compound (6) largely unimpeded.

7. The light-emitting diode arrangement according to one of the preceding claims,
wherein at least one further light-emitting diode (2b) is connected in series to at least one of the light-emitting diodes (2a).

8. The light-emitting diode arrangement according to one of the preceding claims,
wherein at least one of the light-emitting diodes (1, 2) has a light-emitting diode chip in thin-film construction.

9. An optical recording device comprising a light-emitting diode arrangement (11) according to one of the preceding claims.

## Revendications

1. Agencement à diodes électroluminescentes, présentant deux diodes électroluminescentes (1, 2) en montage antiparallèle, et un dispositif (8) qui alimente les diodes électroluminescentes en courant électrique alternatif, dans lequel
- les diodes électroluminescentes constituent une protection mutuelle contre la décharge électrostatique, et
- un matériau de conversion de luminescence (7) qui convertit partiellement la longueur d'ondes d'un rayonnement électromagnétique émis par l'une des diodes électroluminescentes (1), de sorte que le rayonnement électromagnétique de cette diode électroluminescente (1) se mélange à la partie à longueur d'ondes convertie de son rayonnement pour constituer de la lumière blanche,
**caractérisé en ce que**
- la diode électroluminescente à longueur d'ondes convertie (1) émet selon une longueur d'ondes entre 420 nm et 470 nm et le matériau de conversion de luminescence (7) convertit une partie de ce rayonnement en rayonnement électromagnétique d'une longueur d'ondes entre 530 nm et 580 nm, et
- l'autre des diodes électroluminescentes (2) émet un rayonnement électromagnétique dans la zone spectrale rouge selon une longueur d'ondes entre 600 nm et 750 nm, de sorte à accroître un indice de restitution des couleurs.

2. Agencement à diodes électroluminescentes selon la revendication 1, dans lequel le dispositif (8) alimente pendant des intervalles de temps prédéterminables les diodes électroluminescentes en un courant électrique de sens et d'intensité prédéterminables.

3. Agencement à diodes électroluminescentes selon la revendication 1 ou 2, dans lequel le dispositif (8) est un circuit de modulation d'impulsions en durée.

4. Agencement à diodes électroluminescentes selon l'une des revendications précédentes, dans lequel les diodes électroluminescentes (1, 2) sont disposées dans un carter commun (5).

5. Agencement à diodes électroluminescentes selon l'une des revendications précédentes, dans lequel les diodes électroluminescentes (1, 2) sont entourées d'une masse de scellement (6).

6. Agencement à diodes électroluminescentes selon la revendication précédente, dans lequel une des diodes électroluminescentes (2) est appropriée afin d'émettre un rayonnement électromagnétique d'une longueur d'ondes qui pénètre largement sans encombre la masse de scellement (6).

7. Agencement à diodes électroluminescentes selon l'une des revendications précédentes, dans lequel au moins une diode électroluminescente supplémentaire (2b) est branchée en série par rapport à au moins une des diodes électroluminescentes (2a) .

8. Agencement à diodes électroluminescentes selon l'une des revendications précédentes, dans lequel au moins une des diodes électroluminescentes (1, 2) présente une puce à diodes électroluminescentes en structure à film mince.

9. Appareil d'enregistrement optique, présentant un agencement à diodes électroluminescentes (11) selon l'une des revendications précédentes.
